# EUROPEAN PATENT APPLICATION

(11) **EP 4 492 183 A1**
(43) Date of publication of application: **15.01.2025**
(21) Application number: 24382733.4
(22) Date of filing: 09.07.2024
(51) Int. Cl.: G05D 1/617

(54) **APPARATUS MANAGEMENT SYSTEM FOR CONTROLLING AT LEAST ONE FUNCTION OF AN APPARATUS**

(30) Priority: 11.07.2023 EP 23184774; 20.12.2023 EP 23383326
(71) Applicant: Airbus Defence and Space GmbH, 82024 Taufkirchen (DE); Airbus Defence and Space S.A.U., 28906 Getafe, Madrid (ES)
(72) Inventor: NEUMEIER, Stefan, 82024 Taufkirchen (DE); COOK, Alasdair, 82024 Taufkirchen (DE); PÉREZ ACAL, Antonio, 82024 Taufkirchen (DE); RIBAS DE AMARAL, Janaina, 28906 Getafe, Madrid (ES)
(74) Representative: LKGLOBAL Lorenz & Kopf Patentanwalt Attorney at Law PartG mbB

(57) **Abstract**

An apparatus management system (10), in particular a vehicle management system, for controlling at least one function of an apparatus (1), such as a vehicle, operated by an operator (2) and exposed to a potential impact (3) approaching the apparatus (1), as well as a corresponding apparatus (1) and a system training device (200) are provided, the apparatus management system (10) comprising: an impact reaction system (11), configured for generating a command for controlling the at least one function of the apparatus (1); wherein the impact reaction system (11) comprises: an intervention control unit (100); and an operator notification unit (55); wherein the intervention control unit (100) comprises at least one control model configured for assessing at least one command for controlling the at least one function of the apparatus (1) to perform an intervention in order to avoid the impact (3); wherein the operator notification unit (55) is configured to issue at least one notification to the operator (2) regarding the at least one command; and wherein the intervention control unit (100) is configured to output the at least one command for controlling the at least one function of the apparatus (1) subsequent to issuance of the notification.

## Description

### Technical Field

The description relates to controlling an apparatus, in particular a vehicle, with an at least partly automated apparatus management system. In particular, the description relates to an apparatus management system and an aircraft with such an apparatus management system, and to a system training device configured to simulate the behavior of an apparatus operated by an operator and of an impact approaching the apparatus, to provide computer-readable instructions for operating the apparatus management system.

### Technical Background

Partly automated or fully automated systems are used in apparatuses, such as vehicles to assist an operator of the vehicle in controlling the movement of the vehicle or another function of the vehicle. These partly or fully automated systems may be referred to as operator assistance systems and may control the vehicle or a function thereof automatically or may provide control information to the operator who then controls the vehicle or the function thereof based on the provided control information.

Artificial intelligence techniques are used in such operator assistance systems. For example, CN 11 367 1825 A describes a decision-making missile avoidance method based on reinforcement learning. Neural networks that are trained in accordance with the principles of reinforcement learning are used to guide an aircraft in missile avoidance maneuvers. As another example, US 10 558 809 B1 describes a software assurance system for runtime environments with a runtime monitoring system.

Furthermore, CN 112348223 A discloses a missile flight path prediction method based on deep learning, and relates to the technical field of state prediction. The method aims to solve the problems that an existing numerical integration method is low in speed and large in occupied calculation resource during flight path calculation. The missile flight path prediction method based on deep learning is composed of two sub-modules, namely offline learning training and online path prediction, is high in prediction precision and high in calculation speed, does not depend on a numerical integration method needing a large amount of repeated calculation, has online real-time calculation capacity, and the feasibility and accuracy of simultaneously calculating a large amount of flight path data are improved. Meanwhile, the prediction of the flight path of the missile can be accurately realized in different missile prediction initial states, the calculation consumption of the algorithm is low, the online realization can be realized, and besides, the method has the capability of large-scale parallel calculation.

D. G. Lui, G. Tartaglione, F. Conti, G. De Tommasi and S. Santini, "Long Short-Term Memory-Based Neural Networks for Missile Maneuvers Trajectories Prediction," in IEEE Access, vol. 11, pp. 30819-30831, 2023, doi: 10.1109/ACCESS.2023.3262023, state that due to its extensive applications in different contexts, moving target tracking has become a hot topic in the last years, above all in the military field. Specifically, missile tracking research received a great effort, mainly for its importance in terms of security and safety. Herein, traditional solutions, e.g., Interacting Multiple Model (IMM) based on the Kalman estimation theory, achieve good performance under the main restrictive assumption of the a priori knowledge of the target model, so neglecting the unavoidable presence of model uncertainties and limiting the achievable tracking accuracy only by the presence of the measurement noise. With the specific aim of overcoming this narrowness, this work investigates the capability of deep neural networks in predicting the missile maneuvering trajectories in a model-free fashion. The idea is to leverage the Long-Short Term Memory (LSTM) net due to its excellent capability in learning long-term dependencies of temporal information. Two different LSTM-based architectures have been hence designed to predict both position and velocity of a missile using raw and noisy measurements provided by a realistic radar system, exploiting a large database abundant of realistic off-line data. Training results and theoretical derivations are verified through non-trivial scenarios in order to assess the capability of predicting unknown and realistic 3D missile maneuvers. Finally, the proposed approach has been also compared with a performing model-based IMM algorithm, suitably tuned to deal with realistic missile maneuvers, confirming the excellent generalization abilities of the developed data-driven architectures for different datasets.

Z. Wang, J. Zhang and W. Wei, "Deep Learning Based Missile Trajectory Prediction," 2020 3rd International Conference on Unmanned Systems (ICUS), Harbin, China, 2020, pp. 474-478, doi: 10.1 109/ICUS50048.2020.9274953 state that accurately predicting or calculating the missile's flight path is one of the key challenges in applying the missile model to various related simulations. The traditional method used for this task is to use models and numerical integration, which requires a lot of computing resources. In this paper, a deep neural network with two hidden layers is established to predict the missile's flight trajectory, the data generated by the traditional model is used to train and test the network, and the error of the network prediction result is analyzed. Using the trained DNN to predict the missile's flight path is about four times faster than the traditional model, and the prediction error is small.

Chun-Shin Lin and P. G. Raeth, "Prediction of missile trajectory," 1995 IEEE International Conference on Systems, Man and Cybernetics. Intelligent Systems for the 21st Century, Vancouver, BC, Canada, 1995, pp. 2558-2563 vol.3, doi: 10.1109/ICSMC. 1995.538167, deal with the survivability of an airship that is under attack by a missile. The pilot may employ an appropriate maneuver or countermeasure at the right moment to escape from the attack. Real-time prediction of the missile trajectory will help prepare the pilot to take action at the right moment to survive. The missiles considered have a short boosting period followed by a nonpowered period. The proposed technique takes some missile trajectory data at the early stage of the nonpowered period to estimate two of the most important missile parameters for predicting the future trajectory. The complete flying course of the target airship must be known for the prediction. Nine sets of trajectory data, three sets from each of three different types of missiles, are available for this study. One of these nine sets is not used because the impact happens during the boosting period. The developed technique generated good prediction results on these missile flyout data. One merit of the proposed technique is that no a priori knowledge about the missile is needed. Indeed, throughout this study, no information about these missiles has been made available to this researcher. Prediction for the earlier trajectory of the missile including the boosting period has not been studied but relevant issues have been addressed and discussed in the introduction and discussion sections.

### Summary

It may be seen as an object to provide an improved apparatus management system which increases awareness and thus acceptability of artificial intelligence supported apparatus control mechanisms. Furthermore, it may be seen as an object to provide an improved apparatus management system, in particular vehicle management system, which increases the reliability of artificial intelligence supported apparatus control mechanisms. This object is solved by the subject matter of the independent claims.

An apparatus management system, in particular a vehicle management system according to the features of the independent claim is provided. In particular, an apparatus management system, for example, a vehicle management and/or controlling system, for controlling at least one function of an apparatus, such as a vehicle, operated by an operator and exposed to a potential impact approaching the apparatus, the apparatus management system comprising: an impact reaction system, configured for generating a command for controlling the at least one function of the apparatus; wherein the impact reaction system comprises: an intervention control unit; and an operator notification unit; wherein the intervention control unit comprises at least one control model configured for assessing at least one command for controlling the at least one function of the apparatus to perform an intervention in order to avoid the impact; wherein the operator notification unit is configured to issue at least one notification to the operator regarding the at least one command; and wherein the intervention control unit is configured to output the at least one command for controlling the at least one function of the apparatus subsequent to issuance of the notification.

An apparatus, in particular a vehicle, such as an aircraft, is provided, comprising a corresponding apparatus management system.

A system training device is provided, configured to simulate the behavior of an apparatus operated by an operator and of an impact approaching the apparatus, to provide computer-readable instructions for operating a corresponding apparatus management and/or a corresponding apparatus according to claim.

The potential impact may impose a threat to the apparatus, e.g., in that the potential impact may be a missile approaching the apparatus which may be an aircraft or alike. The intervention control unit acts as an execution system responsible for conducting the actual intervention, such as a flight maneuver, by providing the respective control commands to a control interface of the apparatus, e.g., an aircraft (Aircraft Control). The operator notification unit serves as an interaction system responsible for presenting that data received by the Prediction Controller in a way that the operator, such as a pilot, is able to understand, it prepares the apparatus, e.g., aircraft, through an interface to Dependent Aircraft Systems and can transfer data to other assets. Therefore, the Future Maneuver Indication considers gathered simulation data and derives a full maneuver out of it. Depending on what is required by the actual system, different options are possible.

The solution will increase the situational awareness of assets and provide them with the possibility to prepare for the intervention, such as a maneuver. Especially for manned platforms, where an operator, for example a pilot, might face unexpected high g pressure, the system can help to prepare the pilot and thus reduce the probability of a pilot getting blackouts. In addition, the system could interface with the systems of the apparatus, for example an aircraft, which could benefit from the prediction, e.g., pre-inflation of a g-suite, deployment of aerodynamic surfaces for high agility control or feed forward control in flight control systems. Thus, the solution allows apparatuses, for example manned and unmanned aircraft, to indicate an operator, such as a pilot, on what actions will be taken by the apparatus, for example in that an aircraft will perform an actual missile evasion task.

Further developments can be derived from the dependent claims and from the following description.

According to an embodiment of the apparatus management system, the apparatus management system further comprises a future intervention indication module configured to provide information regarding the intervention to be performed in order to avoid the impact. The future intervention indication module will help to explain a specific intervention caused by the command. For example, in case of a missile warning, depending on the respective needs, it can be possible to indicate the pilot (through Pilot Warning) that there will be a maneuver and if required in more levels of detail how the maneuver will look like. Respective details on the maneuver can involve certain metrics regarding how the maneuver will be executed and/or what will be its expected performance (e.g., predicted miss distance of a missile).

According to an embodiment of the apparatus management system, wherein the operator notification unit is configured to issue the at least one notification to the operator as a visual, aural and/or haptic signal. The sort of the signal can be chosen in order to provide the operator with the operator notification in the most convenient, informative, yet non-distractive way. Thereby, the signal can help to inform about the at least one command and a useful manner, in particular, since in the case of an aircraft applications, reaction times to impacts may be very short, in the range of milliseconds.

According to an embodiment of the apparatus management system, the impact reaction system comprises a prediction module including an apparatus simulating unit for simulating a behavior of the apparatus in response to the at least one command for controlling the at least one function of the apparatus, and an impact approximating unit for predicting a behavior of the apparatus that is supposed to defeat the impact, and an impact reaction management unit orchestrating the apparatus simulating unit impact approximating unit to predict the most probable intervention to defeat the impact. The impact reaction management unit can thereby serve as a prediction controller. Such a prediction controller can help to provide a prediction system which makes use of an apparatus simulator, for example, an actual aircraft simulation, involving a trained neural network and an extrapolation model. The extrapolation can be based on a respective flight model, for example, the specific missile model to derive the behavior of the neural network. By extrapolating, e.g., the missile position based on the underlying missile model and running the aircraft simulation with the integrated neural network for some steps into the future, it is possible to obtain the most probable path the aircraft would go based on the inputs provided by the neural network the more the prediction system is executed, the more accurate the future maneuver prediction will be as it will be based on more up to date information, thus controlling the divergence of the prediction model. This information can then be used to augment the pilot or other assets with information about the maneuver.

According to an embodiment of the apparatus management system, the impact reaction management unit is configured to run a simulation cycle for a point of time for which the apparatus simulating unit simulates a behavior of the apparatus in response to the at least one command that is supposed to lead to an intervention intended to defeat the impact, and at least one subsequent simulation cycle for a further point of time for which the apparatus simulating unit simulates a subsequent condition of the apparatus after carrying out the at least one command, and with the impact approximating unit predicting a behavior of the impact in response to the subsequent condition. Thereby, the effect of the command the state of the apparatus and/or the impact can be predicted. This enables to further enhance the prediction system and to choose an appropriate intervention.

According to an embodiment of the apparatus management system, the impact reaction system comprises at least two control models, namely a first control model and a second control model; wherein each of the at least two control models is configured for generating the command for controlling the at least one function of the apparatus, and each of the at least two control models can be selectively put in an active state or an inactive state; and wherein the impact reaction system is configured for selecting one of the at least two control models and putting it in the active state. The avoidance management unit of the impact reaction system may select the control model. The control model may be selected based upon a classification and/or type of the impact, and/or based on a respective operation mode of the apparatus. This enables highly adaptive impact reaction.

According to an embodiment of the apparatus management system, the impact reaction system is configured for selecting the one of the at least two control models and putting it in the active state based on input data including at least one or all of sensor data indicative of a state of the apparatus, impact data indicative of a impact approaching the apparatus, other apparatus state data indicative of a state of third apparatuses in the surroundings of the apparatus. Thereby, the impact reaction system may take into account a functional and/or operational state of the apparatus, the impact and/or of third apparatuses which may interact with the apparatus. This further enhances adaptivity and appropriateness of the impact reaction.

According to an embodiment of the apparatus management system, each control model of the at least two control models is a machine learning model configured for different use cases. The different use cases may consider different operational parameters, in particular the current status and/or involvement of the apparatus in its surroundings and interaction with other systems and apparatuses as well as with the operator. This further helps in enhancing adaptivity and appropriateness of the impact reaction.

According to an embodiment of the apparatus management system, each control model of the at least two control models is trained based on different operating conditions of the apparatus. Hence, the different operating conditions may be taken into account in training respective different control models. Operating conditions may be defined by at least one of environmental conditions and/or apparatus conditions, such as weather conditions, altitude ranges of the vehicle, maneuver capabilities of the vehicle, impact types, available countermeasures of the vehicle, and/or speed ranges of the vehicle. This again helps in enhancing adaptivity and appropriateness of the impact reaction.

According to an embodiment of the apparatus management system, the command for controlling the at least one function of the apparatus is a command for controlling movement of the apparatus, a countermeasure deployment trigger and/or an operator protection measure trigger. The Interface to the apparatus can connect to any of its systems, such as to a Dependent Aircraft Systems that can support in preparing the aircraft and the respective pilot's supporting system, e.g., by inflating the g-suite, an active neck protection system, and/or commanding a pilot neck restraint system to better allow the pilot to take the higher G-loads without warning. It also can support an Auto Ground Collision Avoidance (A-GCAS) system to allow for enhanced terrain avoidance, thus supporting the safety case. Eventually, the Maneuver Transmission can be used to inform other assets about the respective maneuver allowing them to react properly, e.g., by adjusting their flight-paths to intercept a missile or avoid any other kind of an impact during flight and/or or to reduce the risk of collision in close formation flights. Consequently, the operator and/or the apparatus may be effectively protected against the initial impact as well as against any further impacts that may arise by avoiding the initial impact.

At least one of the at least two control models may include more than one neural network, each of the neural networks being configured to generate commands for controlling different functions of the apparatus. Gathered data is being fed into the neural networks (NN) to become trained NN, which then enable the assessment of and thus help to provide control commands. Based on the trained NN, the intervention control unit can act as an execution system responsible for conducting the actual intervention, such as the flight maneuver, by providing the respective control commands to the control interface of the apparatus. This helps in providing sophisticated automatic impact reaction.

According to an embodiment of the apparatus management system, the monitoring unit is configured to monitor the input data and determine if the selected one of the at least two control models fits to the input data.

According to an embodiment of the apparatus management system, the apparatus management system further comprises a monitoring unit, wherein the monitoring unit is configured to monitor the input data and determine if the selected one of the at least two control models fits to the input data. Thereby, the appropriateness of the control model may be monitored. This further helps in providing appropriate impact reaction.

According to an embodiment of the apparatus management system, the apparatus management system further comprises a data recording unit, wherein the data recording unit is configured to record input data provided to the intervention control unit, and output data provided by the intervention control unit. The input data and/or output data can help building a record, such as a intervention history. This helps in further improving the apparatus management system.

According to an embodiment of the apparatus, the apparatus further comprises at least one sensor arrangement wherein the sensor arrangement is communicatively coupled to the apparatus management system and configured to provide sensor data. The sensor data may be provided to the impact reaction system and/or the apparatus simulating unit for providing actual data and/or training data, respectively, for developing certain interventions. This helps in further improving impact reaction.

According to another aspect, a vehicle management system for controlling at least one function of an apparatus, such as a vehicle, is provided. The apparatus management system comprises an impact reaction system that is configured for generating a command for controlling the at least one function of the apparatus. The impact reaction system comprises an intervention control unit and an impact reaction management unit. The intervention control unit comprises at least two control models, namely a first control model and a second control model, wherein each of the at least two control models is configured for generating the command for controlling the at least one function of the apparatus, and each of the at least two control models can be selectively put in an active state or an inactive state. The impact reaction management unit is configured for selecting one of the at least two control models and putting it in the active state. The intervention control unit is configured to output the command for controlling the at least one function of the apparatus provided by the control model that is in the active state.

The at least one function of the apparatus that is controlled by the apparatus management system may relate to the movement of the apparatus (determining one or more movement commands, resulting in a movement trajectory) or to another function of a system or a subsystem of the apparatus.

The intervention control unit includes two or more control models. The control models are provided with input data relating to the apparatus and the apparatus surroundings sensed by sensors (Radar, Lidar, optical cameras, Infrared sensors, acoustic sensors, to name just a few as an example and without limitation) and/or received via a communication interface from an external entity (for example, from an external sensor platform that performs surveillance and provides the surveillance results to consumers, for example via wireless data links). The control models are configured to generate a control command for the apparatus or a system/subsystem of the apparatus based on the received input data.

The input data are then provided to one or more of the control models of the intervention control unit. The control models may operate in parallel and each determines a control command based on the received input data. However, typically only one of the control models is selected to actually control the apparatus or a system/subsystem of the apparatus based on the control command of the selected control model. This is preferably done by transmitting or forwarding the control command of the selected control model (i.e., of the active control model) to the apparatus or to the controlled system/subsystem. Alternatively, the inactive control models (i.e., the control model(s) that is/are not selected for controlling the apparatus or a system/subsystem) may not be provided with input data such that only the selected (active) control model receives input data and, as a result thereof, generates and provides a control command.

In other words, the impact reaction management unit selects one of the control models of the intervention control unit to be put in the active state. When the control model is in the active state, this control model outputs a command, and this command is used for controlling the function of the apparatus. When a control model is in the inactive state, it may be idle or paused. Alternatively, even when in the inactive state, a control model may be provided with input data and may calculate a command. However, the command of a control model that is in an inactive state is not output by the impact reaction system. Thus, in a certain situation, only one control model is active and the command from this active control model is used to command the function of the apparatus while a command from an inactive control model is ignored.

According to an embodiment, the impact reaction management unit is configured for selecting the one of the at least two control models and putting it in the active state based on input data including at least one or all of sensor data indicative of a state of the apparatus, impact data indicative of a missile approaching the apparatus, other apparatus state data indicative of a state of third apparatus in the surroundings of the apparatus.

These data may be collected and concatenated by an information collection unit that is configured for collecting relevant information about the apparatus itself, an approaching missile, and other allied apparatus that may be involved in the countermeasures against the approaching impact, or a ground-, air- or space-based surveillance system or a satellite.

The information collection unit receives data and provides input data based on which one of the at least two control models of the intervention control unit is activated by the impact reaction management unit.

According to a further embodiment, each control model of the at least two control models is a machine learning model configured for different use cases.

For example, the control models may be trained for different scenarios, constraints, mission parameters of the apparatus, and/or different functions of the apparatus to be controlled by the control models. The machine learning model may be a neural network that is trained under certain conditions, or any other artificial intelligence technique, including expert systems.

According to a further embodiment, each control model of the at least two control models is trained based on different operating conditions of the apparatus.

Thus, multiple control models are provided and each of the control models is trained under certain operating conditions (including information relating to an approaching missile). The impact reaction management unit determines the current operating conditions of the apparatus and selects one (or more) control models that are trained under operating conditions matching the current operating conditions or being close to the current operating conditions. Thus, the reliability of the commands created by the selected control models is increased.

According to a further embodiment, the operating conditions are defined by at least one of weather conditions, altitude ranges of the apparatus, intervention capabilities of the apparatus, impact or missile types, available countermeasures of the apparatus, and/or speed ranges of the apparatus.

It is noted that the entries of this list are provided as examples only and not limiting. Other operating condition parameters may be selected to train the control models.

According to a further embodiment, the command for controlling the at least one function of the apparatus is a command for controlling movement of the apparatus and/or a countermeasure deployment trigger.

According to a further embodiment, at least one of the at least two control models includes more than one neural network, each of the neural networks being configured to generate commands for controlling different functions of the apparatus.

Thus, each control model may include different neural networks that are configured for controlling multiple different functions of the apparatus. These neural networks may be trained based on different input data.

According to a further embodiment, the apparatus management system further comprises a monitoring unit, wherein the monitoring unit is configured to monitor the input data and determine if the selected one of the at least two control models fits to the input data.

The monitoring unit makes sure that the selected control model is appropriate for the currently applicable input data. When the parameters of the apparatus mission change, this change may require a change of the selected and active control model. When the monitoring unit determines that the current input data do not fit to the mission criteria the selected control model is selected for, the monitoring unit sends a signal to the impact reaction management unit which initiates a change of a control method (e.g., initiates a recovery intervention or selects another control model).

The monitoring unit may be a separate functional module, like a software module, or it may be implemented as a function of the apparatus management system.

According to a further embodiment, the apparatus management system further comprises a data recording unit, wherein the data recording unit is configured to record input data provided to the intervention control unit, and output data provided by the intervention control unit.

The data recording unit collects data about the apparatus, sensor data, mission scenario, other aircraft states, and/or missile data (input data) and the control commands generated and provided by the intervention control unit (output data). Based on the data recorded by the data recording unit, it may be determined after a mission if the control models have worked appropriately or if they require reconfiguration or modification.

According to another aspect, an aircraft is provided that comprises an apparatus management system as described above and hereinafter.

While, in this aspect, the apparatus management system is described for usage in an aircraft, it may be noted that this is a non-limiting use case. The apparatus management system may be used in spacecraft, watercraft, submarine vessels, or any kind of land vehicle or stationary apparatus.

According to an embodiment, the aircraft further comprises at least one sensor, wherein the sensor is communicatively coupled to the apparatus management system and configured to provide sensor data.

Thus, the apparatus management system receives input data from the at least one sensor for generating the control command. The aircraft may further comprise an antenna or another wireless data transmission interface to receive input data from an external entity which are also used as input data by the apparatus management system.

### Brief description of the drawings

The subject matter will hereinafter be described in conjunction with the following drawing figures, wherein like numerals denote like elements, and wherein:
Fig. 1 is a schematic representation of an apparatus management system in an exemplary form of a vehicle management system;
Fig. 2 is a schematic representation of an intervention control unit in an exemplary form of an intervention control unit of the apparatus management system of Fig. 1;
Fig. 3 is a schematic representation of an exemplary embodiment of an apparatus management system comprising a system training device;
Fig. 4 is a schematic representation of another exemplary embodiment of an apparatus management system comprising a system training device; and
Fig. 5 is a schematic representation of an aircraft with an apparatus management system of Fig. 1.
Fig. 6 is a schematic representation of a notification scheme of the apparatus management system.
Fig. 7 is a schematic representation of exemplary image datasets which can be provided to an output device for notifying an operator of an effect of an intervention measure.

### Detailed description of the drawings

The following detailed description is merely exemplary in nature and is not intended to limit the invention and uses of the invention. Furthermore, there is no intention to be bound by any theory presented in the preceding background or the following detailed description.

The representations and illustrations in the drawings are schematic and not to scale. Like numerals denote like elements.

A greater understanding of the described subject matter may be obtained through a review of the illustrations together with a review of the detailed description that follows.

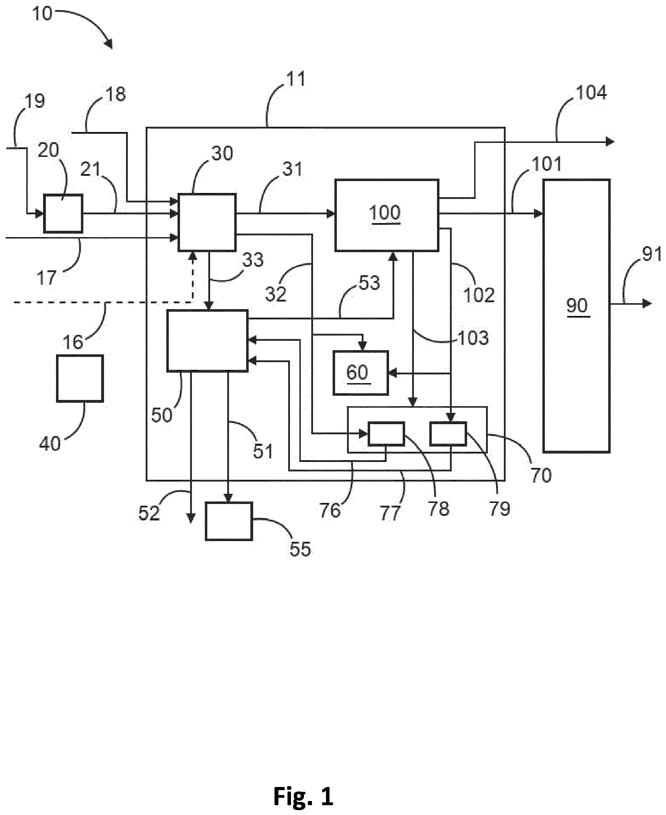

Fig. 1 shows an apparatus management system 10 in an exemplary form of a vehicle management system. The apparatus management system 10 comprises an impact reaction system 11, for example, a missile avoidance system, an apparatus state provisioning unit 20, for example, a vehicle state provisioning unit, and a sensor input provisioning unit 40. For example, the sensor input provisioning unit 40 may receive input data from other sensors and provide those to the impact reaction system 11.

The impact reaction system 11 receives data and determines a control command that is transmitted to a flight control system 90 of the apparatus, such as an aircraft. The flight control system 90 generates commands 91 and transmits the commands 91 to the respective units of the apparatus. Furthermore, the impact reaction system 11 may output warning signals to an operator notification unit 55 or warning system or an availability status 52 that indicates the status of the impact reaction system 11.

The impact reaction system 11 comprises an information collection unit 30, an intervention control unit 100, an impact reaction management unit 50, a data recording unit 60, and a monitoring unit 70.

Based on several information (for example, countermeasure data 16, impact data 17, for example, missile data, other apparatus states 18, sensor data 19) provided directly to the impact reaction system 11 or to the apparatus state provisioning unit 20 and then provided to the impact reaction system 11, the information collection unit 30 generates input data 31. The input data 31 are created by fusing the indicated information and are then sent to the intervention control unit 100. Furthermore, the input data are transmitted to the impact reaction management unit 50 (indicated by arrow 33), to the data recording unit 60, and to the monitoring unit 70 (indicated by arrow 32).

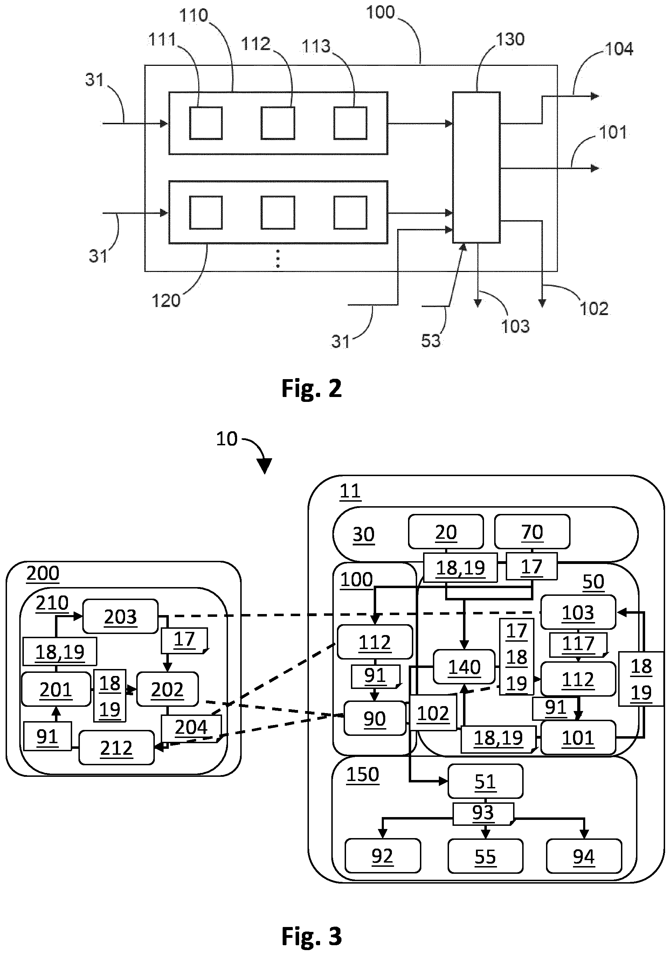

The intervention control unit 100 receives the input data 31 and provides those to the control models (see Fig. 2) to generate a command signal 101 and optionally a countermeasure deployment trigger 104. The generated command signal is also transmitted to the monitoring unit 70 and to the data recording unit 60 (indicated by arrow 102).

The impact reaction management unit 50, for example, a missile avoidance management unit, determines, based on the input data 33, which of the control models of the intervention control unit to select for putting into the active state. The control models may be prepared and trained for different use cases. Depending on the input data, the impact reaction management unit 50 selects the most appropriate control model which is prepared or trained for the current mission scenario. The control model is selected by a selection signal 53 transmitted by the impact reaction management unit 50 to the intervention control unit 100. The intervention control unit 100 sends information about the selected control model to the monitoring unit 70 via signal 103.

The data recording unit 60 receives input data 32 and output data 102 and stores the data in a memory.

The monitoring unit 70 comprises an input monitoring unit 78 and an output monitoring unit 79. The input monitoring unit 78 receives the input data 32 and the output monitoring unit 79 receives the output data 103. Furthermore, the monitoring unit 70 receives a signal 103 indicative of the selected control model. The data of the input monitoring unit 78 and the output monitoring unit 79, i.e., information about availability status and warning based on the monitoring of inputs and outputs, are forwarded to the impact reaction management unit 50 via signals 76, 77.

The monitoring unit 70 monitors the input to the control models and the output of the control models. Furthermore, the monitoring unit 70 knows which control model is selected. Thus, the monitoring unit 70 is able to make sure that the appropriate control model is selected, i.e., that a control model is selected that is prepared and/or trained for the current mission scenario. Based on the data provided by the monitoring unit 70 to the impact reaction management unit 50 and based on the input data 31/32/33, the latter may change the selected control model or initiate a recovery intervention, for example, a recovery maneuver. The impact reaction management unit 50 selects a control model so that each control model acts within an operational design domain (e.g., altitude, weather, type of impact, apparatus state) it is designed for. The monitoring unit 70 is able to identify if the parameters change in a manner that the selected control model is not designed for.

The structure of the intervention control unit 100 is shown in Fig. 2. The intervention control unit 100 comprises at least two control models, shown as first control model 110 and second control model 120. In regards of their basic structure, the control models may be similar or identical to one another. Each control model 110, 120 comprises a pre-processing unit 111, a machine learning model 112, and a post-processing unit 113. In one example that is not shown, the control model may comprise more than one machine learning model to generate more than one control command for different functions of the apparatus.

As can be seen in Fig. 2, the control models 110, 120 receive the input data 31. The input data is pre-processed by the pre-processing unit 111 and forwarded to the machine learning model 112. The result of the machine learning model 112 is post-processed by the post-processing unit 113. The intervention control unit 100 comprises a control model selection unit 130. The control model selection unit 130 receives the input data 31, the control signal 53 from the impact reaction management unit 50, and the output from the different control models. Based thereon, the control model selection unit 130 selects the output of one of the control models and forwards this output as signal 101 to the flight control system 90. Additionally, a countermeasure deployment trigger 104 may optionally be output by the control model selection unit 130. Furthermore, the control model selection unit 130 sends signals 102, 103 to the monitoring unit 70.

In other words, and with reference to a specific implementation example, the functioning of the apparatus management system 10 described with reference to Fig. 1 and Fig. 2 may be described as follows:

The control models 110, 120 receive input data 31 (apparatus state, sensor data, impact information, for example, information regarding a threat to the apparatus, such as missile information, etc.) and generate output signals that are used as a basis for generating movement commands (change direction, velocity, etc.), for example by an operation control system 90, such as a flight control system (FCS), and/or countermeasures, for example by a respective defensive aids system. The apparatus management system 10 can be used in apparatuses like aircrafts or remote carriers that are required to avoid an impact, such as a threat, during operation, for example, missiles during a mission. It allows apparatuses, such as manned and unmanned vehicles to perform interventions, for example, missile avoidance maneuvers, and deploy countermeasures automatically in individual or cooperative way by involving and communicating with third apparatuses, for example, third vehicles. The monitoring unit 70 and the data recording unit 60 make sure that the actions of the apparatus management system 10 are monitored and stored to identify if the appropriate control model is selected and if the selected control model operates appropriately.

By using multiple differently configured control models and selecting one control model based on the current mission status (sensor data, impact information, apparatus status, etc.), the probability of mission success can be increased.

The artificial intelligence (Al) based impact reaction system 10 is responsible for generating commands (e.g., stick commands, countermeasures deployment trigger) using machine learning (ML) models 112 that will guide the apparatus 1 during automatic impact avoidance interventions, for example, like an aircraft during automatic missile avoidance maneuvers, and control the deployment of countermeasures. In order to achieve the most successful evasion, the use of multiple ML models 112 that fit individual conditions (e.g., impact type, apparatus state) can be beneficial. This system 10 can generate only the commands to the operation control system 90 (e.g., FCS) to perform kinetic avoidance by affecting the movement trajectory of the apparatus (option 1) or generate the commands to the FCS 90 and the trigger to deploy countermeasures (option 2). Option 2 allows the apparatus to intervene or maneuver in such a way that the effectiveness of chaffs or flares are optimized. In this case, the system shall decide depending on impact characteristics, environmental conditions (dust, fog, day/night, etc.), apparatus state and other inputs what to do, which countermeasure shall be triggered and when, which intervention to execute before, during and after countermeasure deployment, and what to do afterwards.

Therefore, the system 10 can consist of the following subsystems or units:
(1) impact reaction management subsystem 50 that decides if the automatic intervention can be started or should end. It also sends information to other systems indicating whether the automatic intervention can be started and if it will end (e.g., signals 51, 52, cockpit instrumentation or ground station instrumentation, operator notification unit and warning system). The ML model selection, i.e., the selection of the best suitable ML model 112 (e.g., based on impact type, apparatus state, etc.), can be performed in this subsystem;
(2) intervention controlling subsystem 100 with the capability to perform an intervention with the apparatus (option 1) or perform an intervention with the apparatus and initiate countermeasures (option 2), which contains the ML models 112 (e.g., neural networks) and their data pre-processing units 111 and post-processing units 113 that calculate the commands sent to the FCS 90 and the trigger to deploy countermeasures (option 2). The ML model selection can be performed in this subsystem by the control model selection unit 130;
(3) ML monitoring subsystem 70, which monitors the ML models' 112 inputs and outputs;
(4) ML data recording subsystem 60 that records the ML models' 112 inputs and outputs;
(5) collecting relevant information subsystem 30 that receives the apparatus states, information about the impacts (e.g., from an impact warner system, on-board sensor or from any other external source via datalink (e.g., from an impact warner system located on another platform), radio, optical systems, etc.), information about other apparatus (e.g. position and speed that can be estimated using sensor data or shared via datalink), and the information about the countermeasures (which types are available, number of countermeasures available, etc.) and prepares the relevant information to be sent to the intervention controlling subsystem 100 in accordance with option 1 or option 2 referred to above.

Since the beginning of the flight, the collecting relevant information subsystem 30 will handle the apparatus states, information about impacts and other apparatus and optionally information about countermeasures. This subsystem 30 will send the relevant data such as speed, angle of attack, etc., which will be the input to the ML models 112, to the intervention controlling subsystem 100, ML monitoring subsystem 70, and ML data recording subsystem 60. In addition, it will inform the impact reaction management subsystem 50 when an impact is approaching the apparatus, such as a missile tracking an aircraft.

Once one or more potential impacts are detected as probably approaching the apparatus, such as missiles launched and tracking the aircraft, the ML monitoring subsystem 70 will identify if the inputs are inside the operational design domain (ODD) of the Al-based impact reaction system 11. This information is sent to the impact reaction management subsystem 50 which will allow the automatic impact reaction intervention to be started and will send an availability status to another system (e.g., cockpit instrumentation or ground station instrumentation, like system 55), in case the inputs are inside the ODD. Otherwise, it will send an unavailability status informing that the automatic intervention cannot be started.

The intervention controlling subsystem 100 can contain one or multiple ML models 112 within control models 110, 120. The ML models may consist of one or more elements. For instance, it could contain one neural network or a more complex architecture with several neural networks. For example, if one ML model is not able to perform successfully the avoidance over the whole safe flight envelope, different ML models can be used in different regions or with different types of impacts or countermeasures. Therefore, before starting the intervention, the ML model has to be selected by the impact reaction management subsystem 50 or the intervention controlling subsystem 100, for example. The selected model 112 will guide the apparatus and control the deployment of countermeasures during the entire avoidance intervention as long as no issue is identified by the ML monitoring subsystem 70 (e.g., if the ML model inputs are inside of the ODD and if the outputs are within its performance range).

In order to calculate the required control commands for the avoidance intervention, the intervention controlling subsystem 100 receives the relevant data (e.g., apparatus states, impact and countermeasures data), pre-process them in the pre-processing unit 111 (e.g., normalize the values) and send them as input to the ML models 112. The commands which are the output of the ML models 112 might need to be processed by a post-processing unit 113 to denormalize the values. In the sequence, the output of the selected ML model is sent to the FCS and optionally to the system responsible for the countermeasures deployment.

While the apparatus is performing the intervention, the ML data recording subsystem 60 is recording the ML model inputs and outputs in a defined frequency. Additionally, the ML monitoring subsystem 70 is checking if the inputs are within the operational boundaries and if the outputs are within the performance boundaries. In case the inputs and outputs are not within its respective boundaries, the impact reaction management subsystem 50 will stop the intervention and trigger a warning message (e.g., to the operator notification unit 55).

The AI-based impact reaction system will generate commands to the flight control system 90 and control the deployment of countermeasures only during the impact avoidance intervention, for example, the missile avoidance maneuver.

The ML monitoring subsystem 70 and the ML data recording subsystem 60 are optional, in one example.

The information about other apparatuses as input to the ML model can be relevant and required due to two different aspects: collision avoidance with other apparatuses while performing impact avoidance interventions incorporation with other apparatuses to perform multi-agent impact avoidance, for example, like an aircraft while doing the missile avoidance intervention and cooperation with other aircraft to perform multi-agent missile avoidance. For instance, two unmanned and one manned aircraft could maneuver in such a way that the probability of survival of the manned aircraft is maximized.

Fig. 3 shows a schematic representation of an exemplary embodiment of an apparatus management system 10 comprising a system training device 200. The system training device 200 may be provided in the form of a computing device and/or a server and provides a training system 210. The training system 210 receives the impact data 17 which may be data regarding any kind of possible threat, for example, a missile, which potentially approaches the apparatus 1. Furthermore, the training system 210 receives data regarding other apparatus states 18 and sensor data 19 regarding the apparatus 1. Starting from a certain point of time t, the data is fed into an apparatus simulator 201 a training framework 202 and an impact simulator 203 of the training system 210.

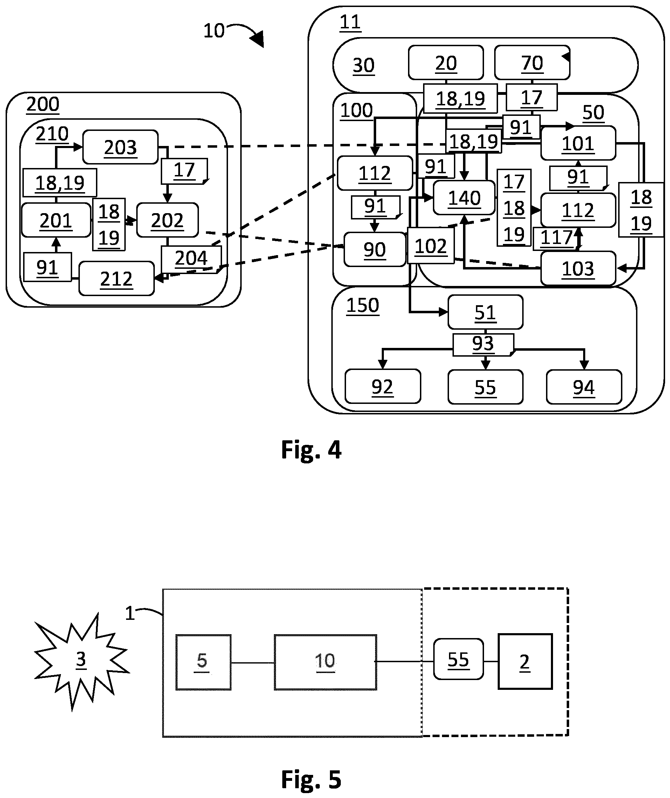

The training system 210 can help in enhancing any command signal 91 issued to the apparatus 1, for example, in a circular fashion. Based on respective apparatus states 18 and sensor data 19, the apparatus simulator 201 simulates a certain behavior of the apparatus 1, such as a trajectory, countermeasures, performance parameters, or alike. The resulting apparatus states 18 and sensor data 19 are fed into the training framework 202. Furthermore, also the impact simulator 203 can receive the apparatus states 18 and sensor data 19 for determining a respective behavior of an impact 3 (see Fig. 5) on the apparatus. The training framework 202 can generate training data 202, for example, training observations, implications of rewarding reactions, etc., to a machine training model 212. The interaction and interdependency of the apparatus 1 and the impact 3 can be assessed in the machine training model 212 to determine those command signals 91 which may be best suited for defeating the impact 3 or at least mitigating it in such a manner that any threat to the apparatus 1 or its surroundings can be avoided. Based on the determined, signals 91, the behavior of the apparatus 1 and of the impact 3 can be determined for a sick sequent point of time t by the apparatus simulator 201 and the impact simulator 203, respectively, for further enhancements and predictions.

The data and outcomes generated by the training system 210 in the system training device 200, for example in an off-line fashion separate from the apparatus 1, can be provided to the impact intervention system 11 implemented it in the apparatus 1. In particular, in parallel to the apparatus simulator 201 of the training system 210, an apparatus simulator 101 can also be run in the impact intervention management unit 50 which can serve as a prediction system. The impact simulator 203 can be implemented in the impact intervention management unit 50 as an impact approximator 103.

The machine learning model 112 runs in line with the machine training model 212, for example, as a version of the machine training model 212 implemented in the apparatus 1, in particular the impact intervention management unit 50. The impact approximator 103 approximates the behavior of the impact 3 and generates respective impact approximation data 117 which is provided to the machine learning model 112. By the approximation of the impact 3 in conjunction with the machine learning model 112, the control commands 91 can be generated that are intended for defeating or at least mitigating the impact 3.

An apparatus simulator 101 or apparatus approximator runs in line with the machine training model apparatus simulator 202, for example, as a version of the machine training model 212 implemented in the apparatus 1, in particular the impact intervention management unit 50. The apparatus simulator 101 again generates respective apparatus states 18 and/or sensor data 19 regarding a possible behavior of the apparatus 1 resulting from the simulation of the control commands 91 by the apparatus simulator 101. Both, the actual apparatus states 18 and/or sensor data 19 gathered by the apparatus state provisioning unit 20 along with the impact data 17 gathered by the monitoring unit 70, and the simulated apparatus states 18 and/or sensor data 19 are fed into a prediction control unit 140 or prediction controller. The prediction control unit 140 can predict the most probable intervention for defeating or at least mitigating the impact 3 and will provide intervention simulation data 102 based respected gathered simulation data for defeating or at least mitigating the impact 3. The intervention simulation data 102 is input into a future intervention identification unit 51.

An interaction system 150 of the impact intervention system 11 can comprise the future intervention identification unit 51, and intervention transmission unit 92, the operator notification unit 55 and an interface unit 94. The future intervention identification unit 51 can process and prepare the planned intervention in such a way that a respective impact indication 93 is output to the intervention transmission unit 92, the operator notification unit 55 and possibly the interface unit 94. The intervention transmission unit 92 may first await notification of the operator 2 (see Fig. 5) by the operator notification unit 55 until the respective intervention is triggered by transferring respective instructions to the intervention control unit 100 which may then issue the corresponding control commands 91 to the operation control system 90 to be executed by the apparatus 1. In parallel, and/or subsequently to the notification, the interface unit 94 can interact with the countermeasure deployment trigger 104 for triggering any appropriate countermeasure identified for defeating and/or at least mitigating the impact 3.

Fig. 4 shows a schematic representation of another exemplary embodiment of an apparatus management system 10 comprising the system training device 200. Here, as an alternative and/or additional functionality of the apparatus management system 10, control commands 91 given by the intervention control unit 100 as an execution system can be first fed to the prediction control unit 140 in order to avoid double calculations to be performed by the machine learning model 112. The control commands 91 assessed by the prediction control unit 140 can then be fed into the apparatus simulating unit 101 to perform the simulations based on respective control commands 91 provided by the machine learning model 112 in order to generate respective apparatus states 18 and/or sensor data 19 to be provided to the impact approximation unit 103, which can then return the approximation data 117 to the learning model 112 for generating false control commands 91 most suitable for defeating or at least mitigating the impact 3.

The prediction of the intervention indication 93 is responsible for augmenting the operator 2 with information on what actions and/or operational directions the apparatus will go while performing an AI (Artificial Intelligence) intervention, such as a guided flight maneuver, for example for missile avoidance as a reaction to a possible impact 3. This is achieved by permanently executing an accurate simulation of the apparatus 1 and the impact 3 based on recent sensor data 17, 18, 19, predicting a variable number of steps into the future to foreshadow/predict the most probable intervention. The prediction system implemented in the prediction control unit 140 is required as AI based interventions are strongly dependent on the respective situation and the environment and thus can perform actions that were not anticipated by the operator 2, for example, a pilot, but put an apparatus, such as aircraft and the operator, i.e., the pilot on their respective limits leading to potentially dangerous situations as the operator is not properly prepared.

This prediction system thus helps to allow the operator 2 and the apparatus 1 to prepare for the specific intervention, such as a maneuver, and to reduce the adjunct risks of extreme interventions, such as high-performance flight maneuvers, during which an aircraft would be controlled by a specific subsystem. The prediction system can generate multiple types of outputs. The first one consists of a respective operator notification that will inform the operator about what is about to come and how the respective intervention might look like (different levels of detail and different types of warning such as visual, audio, haptic). The second output is meant to interface the dependent apparatus systems, which will prepare the apparatus (e.g., g-suite inflate, seat adjustments, in an aircraft) for the intervention. The third and most generic output would indicate the intervention to other assets allowing them to react properly.

Consequently, the apparatus management system 10 can be understood as a threat avoidance system and may thereby become an impact reaction system which may trigger any kind of intervention based on a predicted response of the neural network to an (probably impending) impact. The impact reaction may then still be further specified a possible thread avoidance, i.e., as an optional scenario for causing an intervention in order to avoid a threatening impact. A maneuver can be seen as just an example of an intervention, while an incoming missile can just be a possible threat that could have a certain impact on an apparatus 1 in the form of an aircraft. The impact 3 may thus be any kind of influence that may alter and/or impede an operation of an apparatus 1, such as a vehicle, in particular an aircraft, but also ground vehicle, vessel, or any other kind of complex apparatus which interacts with its environment and possible internal and/or external impacts, such as power plants, communication systems, chemical plants, reactors, or alike, which may involve multiple sensors and actors which may be involved in respective apparatus management systems 10.

Fig 5 schematically shows an apparatus 1, in this example a vehicle in the form of an aircraft, with an apparatus management system 10 as described with reference to Figs. 1 and 2. The apparatus 1 further comprises a sensor arrangement 5 with one or multiple sensors for detecting the surroundings of the apparatus 1. An operator 2 may manually and/or automatically control the apparatus 1 and may therefore be located in or around the apparatus 1, or may control the apparatus 1 from a remote location.

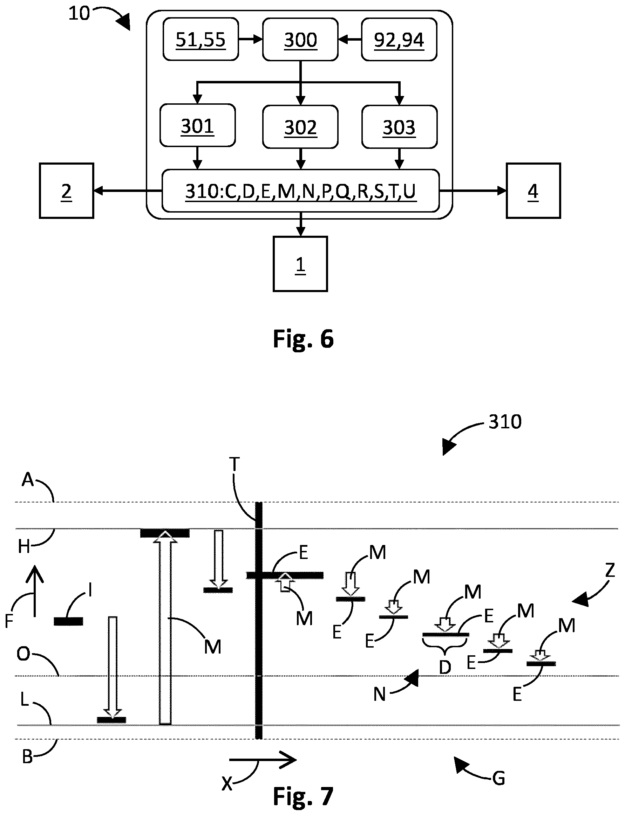

Fig. 6 shows a schematic representation of a notification scheme of the apparatus management system 10. The future intervention and identification unit 51 and/or operator notification unit 55 as well as the intervention transmission unit 92 and/or interface unit 94 can be capable of generating a number of outputs 300, comprising a first output 301, a second output 302 and/or a third output 303 which can be directed to the apparatus 1, the operator 2 /or to another entity 4. The first output 301 can involve a notification N, such as a pilot warning, issued by the operator notification unit 55 that will inform the operator 3 about a potential impact 3 that is about to come and/or how a respective intervention measure M according to the respective intervention indication 93, such as a manoeuvre, might look like (different levels of detail and different types of warning such as visual, audio, haptic). The notification N could be of many different types.

An output device 310, such as a visual display, like a head-up display (HUD), an audio speaker, and/or active control member, such as an active control stick, a digital and/or analogue transceiver module and/or interface for analogue, digital, radio and/or light signal transmission, or alike, can indicate the notification N, for example, in that the output device 310 could warn the operator 2 of an effect E of the intervention measure M, for example in that a pilot as an operator 2 is warned of a high g load vector as an effect E of an evasion manoeuvre by means of an arrow on the HUD indicating both the strength and direction of the impending g-load. Furthermore, the notification N can involve indication of a duration D, such as time span, including a start and/or end time of the intervention measure M and/or the effect E. This could be predicting a fixed time into the future (e.g., 1 second), or be an operator selectable time. A more simplistic warning could also be indicated to the pilot by means of symbols S, such as boxed text and/or audible speech outputs and/or or flashing symbology indicating the incoming high g load, but no indication of direction or value.

The operator 2 can be informed visually by means of the respective symbols S about characteristics of the effect E and/or the intervention measure M. For example, in case of a manoeuvre, the symbols S can help to indicate a maximum/minimum speed and acceleration; minimum distance to other formation members and obstacles; accuracy of the manoeuvre prediction; and prediction of the task success, i.e., the probability of not being hit by the impact 3 such as a missile, or alike. This also includes that the symbols S may indicate where the impact 3, e.g., a missile, is and how it is moving combined with information about predicted missile detonation time and type of missile.

Upon issuing a request R to the operator notification unit 55, the operator 2 can get access to more detailed information like possible threats, and graphical representations of how certain parameters P including any kind of an aircraft attitude values, for instance, a roll rate, a pitch rate, a speed, an acceleration, and/or an altitude value are going to change over time. This can be accompanied by displaying the actual performance region in which the intervention control unit 100 and any involved machine learning model 3, for example, a respective neural network, is able to perform the intervention measure M as an avoidance task in combination with an indicator of where the current flight situation is in contrast to certain boundaries to the intervention measure M, such as limited capabilities of the respective apparatus 1, for example aircraft capabilities, involving maximum allowed and/or possible accelerations, speeds, g-loads, or alike. The operator notification unit 55 can also offer information to be provided to the operator 2 by means of the output device 310 concerning a potential corridor in which the apparatus 1, such as an aircraft, is likely to end up after the intervention measure M and allow the operator to adjust to the situation in which he will take-over the control of the apparatus 1 again.

In general, there may not only be a notification N given by means of the output device 310 when the system is performing the actual intervention measure M, but status indicators T can be present during the whole operation of the apparatus 1. Those status indicators T may consist of values that indicate whether the system is ready at all, ready to take over if any kind of awareness regarding a potential impact 3 is available, such as if a missile is launched and an indicator of the operational mode, e.g., automatic takeover, takeover after pilot confirmation, takeover after certain duration D, such as a number of seconds.

In addition to those basic indicators, there can be indicators regarding the utilisation U of the apparatus management system 10, for example output by the output device 310, that can inform the operator 2 about in which region of the capabilities of the neural network involved in the apparatus management system 10, the apparatus 1 is currently operating, for example, where the pilot is currently flying an aircraft and whether the apparatus management system 10 is able to take over control of the aircraft in the current region (flight state) and whether there are safety margins left or is it already on a certain operational boundary and thus small deviations of the flight by a pilot might render the apparatus management system 10 deactivated.

Any of the above notifications N and involved parameters regarding a duration D, effect E, intervention measure M, notification N, power P, request R, symbols S, status indicators T and/or utilisation indicators U can also be provided by the output device 310 in the form of audio signals, such as warning signals, including voice warnings and peep and/or horn style sound warnings indicating the immanent onset of a certain effect E and/or parameters P, e.g., a high g-force demand. In addition, the apparatus management system 10 could create audio warnings to abort the task or take over control in specific situations, for example, when there is the possibility of mid-air collision or leaving the operation design domain that the neural network was trained for. Voice outputs are additionally capable of giving basic information about specific elements such as the beginning of the automated avoidance manoeuvre, the handing back of control after ending of the manoeuvre and other important events, such as a detection of another potential impact 3, e.g., the launch of a second missile or reaching specific operational boundaries of the apparatus 1 and/or apparatus management system 10.

An active control stick, such as sidestick could be used as a part of the output device 310 to move the stick in the operator's hands, such as the pilots pilot's hand, to the position that the apparatus control system 10 will demand, for example, for taking back control by the operator 2, as a control command C and/or control prediction Q ahead of time, informing the operator 2 about what is going on. The stick can also start to shake slightly while the apparatus control system 10 is performing the evasive intervention measure M, such as a manoeuvre, in order to indicate to the operator 2 that the apparatus control system 10 now temporarily has taken over control of the apparatus 1. As soon as the stick stops shaking, the operator 2 can be made aware of that he is going to be or has been handed over control of the apparatus 1 again.

The second output 302 can relate to any information provided and/or intended to be provided to the apparatus 1 itself, in particular by the intervention transmission unit 92 and/or interface unit 94 interfacing apparatus systems, such as the dependent aircraft systems, which will prepare the aircraft (e.g., g-suite inflate, seat adjustments) for an intervention measure, e.g., manoeuvre. In the present example, aircraft systems that could benefit from being provided with respective notifications N, in particular regarding certain parameters P, such as a high angel of attack (AoA) and/or normal acceleration (nz) situation ahead of time would include g-suit inflation, control surface preparations (e.g., moving the leading edge into a high AoA position to assist in manoeuvrability through the expected AoA range) and aircraft flight control systems (FCS) utilisation of feed forward paths being activated at an early point of time.

Alternatively, or additionally, the second output 302 may trigger a health check of different systems to ensure that the apparatus 1, such as an aircraft, can safely perform the predicted intervention measure M, e.g., a manoeuvre. The present example, other systems, such as the ejection seat can be put in a prerelease state in order to be prepared for an emergency ejection if the system recognises that the performed manoeuvre might not be successful, and a hit is likely to happen. This can help the pilot to eject faster or even do an auto-ejection if the hit is very likely. The manoeuvre supporting dispersion of chaffs and flares is also another system that might be triggered by the apparatus management system 10.

The third output 3 can be provided to other entities 4, such as other apparatuses, systems, devices and/or installations outside of the apparatus 1 which may benefit from being provided with the respective notification N. For example, the apparatus management system 10 can inform other unmanned assets associated with and/or accompanying the aircraft to support the manoeuvre by distracting or intercepting the missile, e.g., by collaborative threat evasion tactics. Consequently, the third output 3 allows for jointly countering any threat and/or potential impact 3 to the apparatus 1 and/or other entity 4 by collaborative implementation of at least one intervention measure M by the apparatus 1 and/or other entity 4.

The apparatus management system 10, in particular the intervention control unit 100 thereof, can be made responsible for conducting the actual intervention measure M, such as a flight manoeuvre, by providing the respective control commands C to a control interface of the apparatus 1 (Aircraft Control) and/or the other entity 4, such as another aircraft, unmanned air vehicle, a missile, an air defence system, or alike. Respective control commands C can include many ways of controlling involved entities. In the present example, the apparatus 1 in the form of an aircraft can be at least controlled by virtual stick commands in the same way a pilot would. However, other more outer, or inner loop commands could also be used. Examples of such commands which are more outer loop would include trajectory generation commands (climb, descend, roll to bank angle X°, etc.) and more inner loop commands could include control commands C like pitch rate, g-dot, or even control surface position commands.

Fig. 7 shows a schematic representation of exemplary image datasets G which can be provided to the output device 310, such as a visual display, like a head-up display (HUD), by means of the future intervention and identification unit 51 and/or operator notification unit 55 as well as the intervention transmission unit 92 and/or interface unit 94 to provide notifications N to inform the operator 2 of an effect E of the intervention measure M. In the present example, the image data sets G are configured to provide graphical representations to inform a pilot as an operator 2 of certain g load vectors occurring as an effect E of an evasion manoeuvre carried out as an intervention measure M. Furthermore, the notification N can involve indication of a duration D, such as the time span, including the start and/or end time of the respective intervention measure M and/or the effect E thereof.

The image datasets G and/or data subsets thereof can comprise data compositions and/or objects representing limit values A, B, H, L, initial values I, durations D, intervention results F, intervention measures M, notifications N, zero values O, status indicators T and/or progresses X as exemplary parameters P as desired or required. The limit values A, B, H, L can comprise an upper apparatus limit A, a lower apparatus limit B, an upper intervention limit H and/or a lower intervention limit L. The upper apparatus limit A and the lower apparatus limit B may indicate respective technical capabilities of the apparatus 1, such as a maximum or minimum design parameter, respectively, allowing for intervention results F which the apparatus 1 may be able to bear, sustain or tolerate within its respective physical boundaries, such as maximum g-force or any other force which may be indicated as an intervention result F on an ordinate of a diagram as illustrated.

The upper intervention limit H and the lower intervention limit L should remain within the boundaries of the respective apparatus limits A, B for each of the intervention measures M as indicated. For example, the notifications N may comprise the intervention measures M along with their duration D and effect E. The duration D of the respective intervention measure M can be provided as a duration value determining a length of a respective image dataset G indicating the effect E. The length can be measured along the respective progress X, such as a time progress measured in minutes, seconds, milliseconds, or alike. The effect E can be indicating the respective intervention result F, such as a resulting g-force positioned with respect to an ordinate for scaling the intervention result F in the present example.

The image dataset G indicating the intervention measure M can be provided as an arrow pointing at the respective effect E, thus informing the operator on the amount and direction of g forces to be expected from a respective manoeuvre carried out as an intervention measure M. The initial value I can be provided as a current value and/or starting value indicating from where on at least one intervention measure M has been or will be initiated. The zero value O can indicate a neutral state of the apparatus 1, such as an acceleration free state, where no intervention results F, e.g., no g-forces would act upon the apparatus 1. The status indicator T can indicate the current state of the intervention measure M and its effect E on the apparatus 1

Any of the notifications N and involved parameters regarding a duration D, effect E, intervention measure M, notification N, parameters P, request R, symbols S, status indicators T and/or utilisation indicators U can be provided by the output device 310. In the present example, in order to support a pilot as the operator 2 in the preparation and understanding of the intervention measure, i.e., manoeuvre, ahead, the respective image datasets G can be provided to the operator 2 in the form of visual clues - either project into the helmet (HUD) or onto one of the displays of the apparatus 1 - that show the respective effect E as a result F in the form of a maximum g-level and its direction during the manoeuvre. In addition, the operator 2, e.g., pilot, can be given further information on how big the effected changes are and what to is to be expected.

The apparatus limits A, B can be provided as dotted lines indicating the maximum capable g an aircraft can fly in positive and negative load, respectively. The intervention limits H, L in the form of solid lines can indicate the maximum load potentially requested during the manoeuvre allowing the pilot to get a fast impression on what to expect. The effects E can be illustrated as bars indicating the duration D of the specific phase of the manoeuvre based on their width measured along the abscissa of the literary diagram as the progress X in time, while their vertical position measured along the ordinate indicating the intervention result F indicates a maximum force or effect value in the respective stage of an intervention measure M.

As shown in the present exemplary illustration, the initial value I can be provided as a bar indicating the starting position of the aircraft. The length of the arrows representing the respective intervention measure M indicate the transition the aircraft goes through, i.e., the longer the arrow, the greater is the change of the requested g load. The status indicator T can be provided as a vertical bar indicating the current state/phase of the manoeuvre while crossing the respective effect E provided as a horizontal bar shows the maximum g load to be expected during the phase of the current manoeuvre. The aircraft's current movement can be indicated for example by a flight direction indicator. Visuals provided by means of respective image datasets G can also be adjusted based on their styles as they are mainly dependent on the aircraft type and potential for displaying.

Consequently, the notifications N and involved parameters regarding a duration D, effect E, initial value I, intervention measure M, notification N, parameters P, request R, symbols S, status indicators T and/or utilisation indicators U as well as apparatus limits A, B and/or intervention limits H, L can constitute a succession or sequence Z of commands C, notifications N and/or respective intervention measures M. The sequence Z can be provided as an output 300 and/or to the output device 310. In order to be displayed and/or signalised to an operator 2 the sequence Z can be provided in the form of at least one image dataset G. The sequence Z represents and indicates how the apparatus management system 10, in particular the impact intervention system 11 and/or intervention control unit 100, intends to avoid the impact, and may be constantly updated. The status indicator T may indicate which part of the sequence Z is currently executed, thus further increasing awareness of an operator 2 regarding the commands C and respective intervention measures M to be expected to be automatically executed.

While at least one exemplary embodiment has been presented in the foregoing detailed description, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It will be understood that various changes may be made in the function and arrangement of elements described in an exemplary embodiment without departing from the scope of the claims.

Additionally, it is noted that "comprising" or "including" does not exclude any other elements or steps and "a" or "an" does not exclude a multitude or plurality. It is further noted that features or steps which are described with reference to one of the above exemplary embodiments may also be used in combination with other features or steps of other exemplary embodiments described above. Reference signs in the claims are not to be construed as a limitation.

### List of reference signs

- 1: apparatus / vehicle, e.g., aircraft
- 2: operator
- 3: impact
- 5: sensor arrangement
- 10: apparatus management system / vehicle management system
- 11: impact intervention system / missile avoidance system
- 16: countermeasure data
- 17: impact data / threat or missile data
- 18: other apparatus states, e.g., vehicle states
- 19: sensor data
- 20: apparatus state provisioning unit / vehicle state provisioning unit
- 30: information collection unit
- 40: sensor input provisioning unit
- 50: impact intervention management unit / missile avoidance management unit
- 51: future intervention identification unit
- 52: availability status
- 55: operator notification unit / warning system
- 60: data recording unit
- 70: monitoring unit
- 78: input monitoring
- 79: output monitoring
- 90: operation control system / flight control system
- 91: command signals
- 92: intervention transmission unit
- 93: intervention indication
- 94: interface unit
- 100: intervention control unit / maneuver control unit
- 101: apparatus simulating unit / apparatus simulator / approximator
- 102: intervention simulation data
- 103: impact approximation unit / impact approximator
- 104: countermeasure deployment trigger
- 110: first control model
- 111: pre-processing unit
- 112: machine learning model
- 113: post-processing unit
- 117: impact approximation data
- 120: second control model
- 130: control model selection unit

- 200: system training device
- 201: apparatus simulating unit / apparatus simulator
- 202: training framework
- 203: impact simulating unit / impact simulator
- 204: training data
- 210: training system
- 212: machine training model

- 300: output
- 301: first output
- 302: second output
- 303: third output
- 310: output device

- A: limit value / upper apparatus limit
- B: limit value / lower apparatus limit
- C: control command / control value
- D: duration
- E: effect
- F: intervention result / force
- G: image dataset
- H: limit value / upper intervention limit
- I: initial value / current state
- L: limit value / lower intervention limit
- M: intervention measure
- N: notification
- O: zero value / neutral state
- P: parameter
- Q: control prediction
- R: request
- S: symbols
- T: status indicator
- U: utilisation indicator
- X: progress / time
- Z: sequence

## Claims

1. An apparatus management system (10), in particular a vehicle management system, for controlling at least one function of an apparatus (1), such as a vehicle, operated by an operator (2) and exposed to a potential impact (3) approaching the apparatus (1), the apparatus management system (10) comprising:
an impact reaction system (11), configured for generating a command for controlling the at least one function of the apparatus (1);
wherein the impact reaction system (11) comprises:
an intervention control unit (100); and
an operator notification unit (55);
wherein the intervention control unit (100) comprises at least one control model configured for assessing at least one command for controlling the at least one function of the apparatus (1) to perform an intervention in order to avoid the impact (3);
wherein the operator notification unit (55) is configured to issue at least one notification to the operator (2) regarding the at least one command; and wherein the intervention control unit (100) is configured to output the at least one command for controlling the at least one function of the apparatus (1) subsequent to issuance of the notification.

2. The apparatus management system (10) of claim 1, further comprising a future intervention indication module (51) configured to provide information regarding the intervention to be performed in order to avoid the impact (3).

3. The apparatus management system (10) of claim 1 or 2,
wherein the operator notification unit (55) is configured to issue the at least one notification to the operator (2) as a visual, aural and/or haptic signal.

4. The apparatus management system (10) of any one of the preceding claims,
wherein the impact reaction system (11) comprises a prediction module (12) including
an apparatus simulating unit (101, 201) for simulating a behavior of the apparatus (1) in response to the at least one command for controlling the at least one function of the apparatus (1), and
an impact approximating unit (103, 203) for predicting a behavior of the apparatus (1) that is supposed to defeat the impact (3), and
an impact reaction management unit (50) orchestrating the apparatus simulating unit (101, 201) impact approximating unit (103) to predict the most probable intervention to defeat the impact (3).

5. The apparatus management system (10) of claim 4,
wherein the impact reaction management unit (50) is configured to run a simulation cycle for a point of time (t) for which the apparatus simulating unit (101, 201) simulates a behavior of the apparatus (1) in response to the at least one command that is supposed to lead to an intervention intended to defeat the impact (3), and
at least one subsequent simulation cycle for a further point of time (t + n) for which the apparatus simulating unit (101, 201) simulates a subsequent condition of the apparatus (1) after carrying out the at least one command, and with the impact approximating unit (103) predicting a behavior of the impact (3) in response to the subsequent condition.

6. The apparatus management system (10) of any one of the preceding claims,
wherein the impact reaction system (11) comprises at least two control models, namely a first control model (110) and a second control model (120);
wherein each of the at least two control models is configured for generating the command for controlling the at least one function of the apparatus (1), and each of the at least two control models can be selectively put in an active state or an inactive state; and
wherein the impact reaction system (11) is configured for selecting one of the at least two control models and putting it in the active state.

7. The apparatus management system (10) of claim 6,
wherein the impact reaction system (11) is configured for selecting the one of the at least two control models and putting it in the active state based on input data (31) including at least one or all of sensor data (19) indicative of a state of the apparatus (1), impact data (17) indicative of an impact approaching the apparatus (1), other apparatus state data (18) indicative of a state of third apparatuses in the surroundings of the apparatus (1).

8. The apparatus management system (10) of claim 6 or 7,
wherein each control model of the at least two control models is a machine learning model configured for different use cases.

9. The apparatus management system (10) of claim 8,
wherein each control model of the at least two control models is trained based on different operating conditions of the apparatus.

10. The apparatus management system (10) of any one of the preceding claims,
wherein the command for controlling the at least one function of the apparatus (1) is a command for controlling movement of the apparatus, a countermeasure deployment trigger and/or an operator protection measure trigger.

11. The apparatus management system (10) of any one of claims 7 to 10, further comprising a monitoring unit (70),
wherein the monitoring unit (70) is configured to monitor the input data (31) and determine if the selected one of the at least two control models (110, 120) fits to the input data.

12. The apparatus management system (10) of any one of the preceding claims, further comprising a data recording unit (60),
wherein the data recording unit (60) is configured to record input data (31) provided to the intervention control unit (100), and output data provided by the intervention control unit (100).

13. An apparatus (1), in particular a vehicle, such as an aircraft, comprising an apparatus management system (10) of any one of the preceding claims.

14. The apparatus (1) of claim 10, further comprising at least one sensor arrangement (5),
wherein the sensor arrangement (5) is communicatively coupled to the apparatus management system (10) and configured to provide sensor data.

15. A system training device (200) configured to simulate the behavior of an apparatus (1) operated by an operator (2) and of an impact (3) approaching the apparatus (1), to provide computer-readable instructions for operating the apparatus management system (10) according to any one of claims 1 to 12, and/or the apparatus according to claim 13 or 14.
